# EUROPEAN PATENT APPLICATION

(11) **EP 2 408 020 A1**
(43) Date of publication of application: **18.01.2012**
(21) Application number: 10750310.4
(22) Date of filing: 10.03.2010
(51) Int. Cl.: H01L 31/052

(54) **HIGH-EFFICIENCY THREE-DIMENSIONAL SOLAR CELL AND METHOD FOR MANUFACTURING THE SAME**

(30) Priority: 11.03.2009 CN 200910118969
(71) Applicant: Yang, Zhenyu, Hunan 411202 (CN)
(72) Inventor: Yang, Zhenyu, Hunan 411202 (CN)
(74) Representative: Clegg, Richard Ian
(86) International application number: PCT/CN2010/000295
(87) International publication number: WO 2010/102514

(57) **Abstract**

A high-efficiency three-dimensional solar cell is provided, which is suitable for any place needing electric energy, comprising civil houses, public places, factories, and transportation vehicles. The solar cell comprises a photoconductive medium, a photoelectric cell (3) and a light reflection medium. Light is focused on the photon-absorbing surface of the photoelectric cell by a light condenser (5). Light is repeatedly reflected on the photoelectric cell, so that the photoelectric cell can obtain a great number of photons at any time and the conversion efficiency of the photoelectric cell can be improved. A method for manufacturing the high-efficiency three-dimensional solar cell is also provided.

## Description

### Background of the Present Invention

### Field of Invention

The present invention relates to a high-efficiency three-dimensional solar cell, comprising a light guiding medium, a solar cell or a solar cell pack and a light reflecting medium, and a manufacturing method thereof

### Description of Related Arts

The photovoltaic conversion efficiency of a conventional solar cell is at most around 35%. Besides, the surface of the solar cell must face the sun. In strong sunlight, the amount of photons per square on the photovoltaic conversion layer saturates and all of the rest photons, except the photons absorbed by the photovoltaic conversion layer of the solar cell, are reflected out; in dim sunlight, there is still a small amount of photons reflected out. The reflected out photons means that the conventional solar cell has a low solar utilization ratio, which leads to a large area per kilowatt hour and high costs of the conventional solar cell. No matter how inventors change the formula of the photovoltaic conversion layer of the solar cell, the capacity of absorption and conversion of photons per square on the photovoltaic conversion layer of the solar cell is certain, and thus it is difficult to satisfy people's needs of a small area per kilowatt hour and low costs for a solar cell through the conventional method of facing the photovoltaic conversion layer of the solar cell to the sunlight directly to absorb photons, which brings great restrictions to the wide promotion and application of the solar cells.

### Summary of the Present Invention

An object of the present invention is to improve a photovoltaic conversion efficiency of a solar cell and a conversed quantity of electric charge per square in the sunlight, to reduce costs of photovoltaic conversion greatly and to save limited resources. Moreover, in the aspects of stability and reliability, the present invention precedes all of the conventional solar cells.

Thus, according to one aspect of the object of the present invention, the present invention comprises a light guiding medium, high-efficiency solar cells and a light reflecting medium in detachable or fixed connection to each other.

By using a light guiding medium to have sunlight photons' even radiation or reflection on a solar cell or a solar cell pack, and, with a saturation of photon absorption on the solar cell or the solar cell pack, using a light reflecting medium to have the unabsorbed photons' radiation or reflection on the solar cell or the solar cell pack from another angle, no matter in strong light or dim light, the object of improving solar cells' photovoltaic efficiency can be realized.

According to another aspect of the object of the present invention, a light focusing high-efficiency three-dimensional solar cell, made in detachable or fixed connection, comprises: a light focusing body comprising one or more pieces of convex lens made of a light guiding medium material in detachable connection or fixed connection, a light focusing and guiding body made of the light guiding medium material in central symmetry or dissymmetry with the light focusing body, and a high-efficiency solar cell or several high-efficiency solar cells circling around, wherein the high-efficiency solar cells are separated by light guiding mediums, or a side of the light guiding medium is the high-efficiency solar cell, another side of the light guiding medium is the light reflecting medium, or the high-efficiency solar cells coil around, the high-efficiency solar cells are separated by the light guiding mediums, or a side of the light guiding medium is the high-efficiency solar cell, another side of the light guiding medium is the light reflecting medium, and further an output part of the high-efficiency solar cells; another light non-focusing high-efficiency three-dimensional solar cell, made in detachable or fixed connection, comprises a high-efficiency solar cell or several high-efficiency solar cells circling around, wherein the high-efficiency solar cells are separated by light guiding mediums, or a side of the light guiding medium is the high-efficiency solar cell, another side of the light guiding medium is the light reflecting medium, or the high-efficiency solar cells coil around, the high-efficiency solar cells are separated by the light guiding mediums, or a side of the light guiding medium is the high-efficiency solar cell, another side of the light guiding medium is the light reflecting medium, and further an output part of the high-efficiency solar cells.

With sunlight condensed on the light guiding body by the light focusing body, the high-density photons evenly radiate or reflect on the high-efficiency solar cell or solar cell pack from different angles through the light reflecting medium and the light guiding medium which are plated on the output part of the high-efficiency solar cells; or with sunlight directly radiating on the light guiding medium, the photons radiate or reflect on the high-efficiency solar cell or solar cell pack from different angles under the conduction of the light guiding body and the light reflecting body.

According to another aspect of the obj ect of the present invention, the high-efficiency solar cell is in detachable or fixed connection on a substrate to form a two-sides solar cell or a solar cell pack; or has one side of the solar cells or the solar cell packs and another side of the light guiding medium, in detachable or fixed connection on a substrate.

Thus the photovoltaic conversion cost is greatly reduced and limited resources are saved.

According to another aspect of the object of the present invention, the substrate is made of a heat conducting medium in detachable or fixed connection with either of the output electrodes of the solar cell or the solar cell pack, so as to become the passage for heat exchange between the solar cells or the solar cell packs and the outside.

According to another aspect of the present invention, the output part of the high-efficiency solar cell comprises a conductor, an insulation material and a light reflecting material in detachable or fixed connection, so as to be a heat exchanger for exchanging heats with insulation gas or liquid.

Thus as working efficiently, the present invention has two features of outputting heats and electricity as a high-efficiency solar cell. Under whatever conditions, the present invention is able to work highly efficiently to ensure normal electricity outputting.

According to another aspect of the obj ect of the present invention, each convex lens on the light focusing body of the high-efficiency three-dimensional solar cell has its focus or light focusing range located within a flat scope on the light guiding body along the central vertical axis of the convex lens.

Whatever position the sun locates at, the present invention is always in highly efficient operation state.

According to another aspect of the object of the present invention, the light guiding body of the present invention comprises convex lenses and halves of convex lens or convex lenses, concave lenses and halves of convex lenses in detachable or fixed connections.

### Brief Description of the Drawings

Fig. 1 is a sectional view of a light focusing high-efficiency three-dimensional solar cell according to a preferred embodiment of the present invention.
Fig. 2 is a sectional view of a light non-focusing high-efficiency three-dimensional solar cell according to another preferred embodiment of the present invention.

### Detailed Description of the Preferred Embodiment

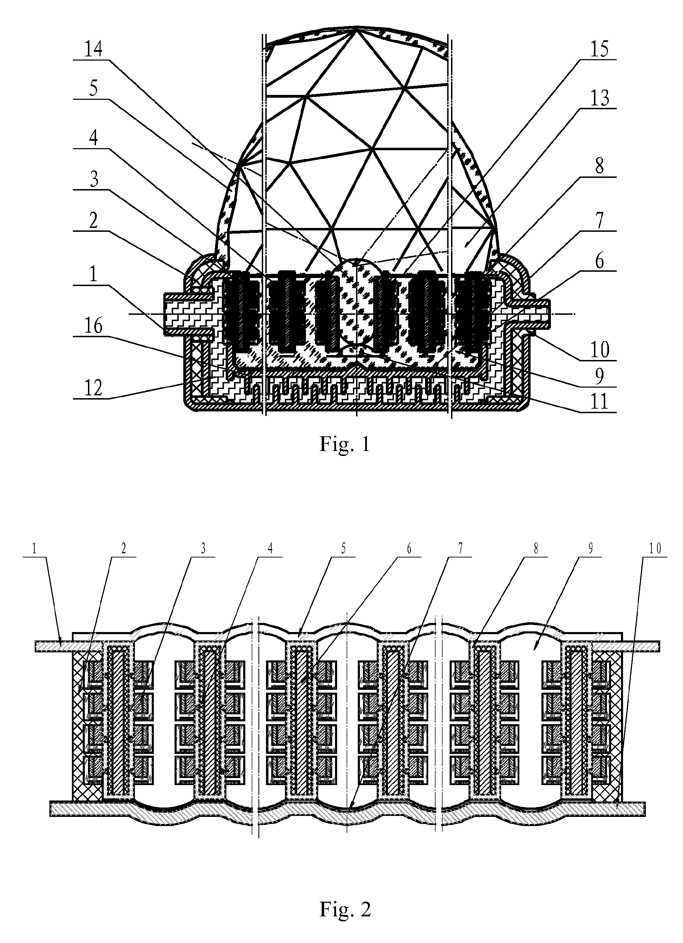

Referring to Fig. 1 of the drawings, a light focusing high-efficiency three-dimensional solar cell comprises an output part of the high-efficiency solar cell, high-efficiency solar cells 3, a light focusing body 5, a light guiding body and a light reflecting part.

The output part of the high-efficiency solar cell is as follows. A combination comprising heat conducting substrates 6 of the high-efficiency solar cells 3, a first electrode 1 for outputting electricity made of close connection, an insulation covering 2 sleeved on the output part of the high-efficiency solar cells, a second electrode 10 for outputting electricity of the output part of the high-efficiency three-dimensional solar cell, and insulation liquid 12 running between the two electrodes of the output part of the high-efficiency three-dimensional solar cell, gives the present invention a dual outputting feature of outputting heat through heat exchange between the heat conducting substrates 6 of the high-efficiency solar cells 3 and the insulation liquid through the two electrodes for outputting electricity 10 and 1, and outputting electricity of the high-efficiency three-dimensional solar cell.

The light focusing body 5 is as follows. The light focusing body 5, made of a light guiding material, is a hollow object having several spherical convex lenses fixedly connected to form a hemisphere, wherein a focus of each double-sided spherical convex lens 13 of the light focusing body 5 locates at the center of the hemisphere having the several spherical convex lenses in fixed connection. Therefore, whatever position the sun locates at, the center of the light focusing body 5 always has high-density photons.

The light guiding body is as follows. A double-sided spherical convex lens 14 and a single-sides spherical convex lens 11 equalize the high-density photons.

The high-efficiency solar cells 3 are formed as follows. An insulating layer 4 and an electrodes layer 8 of the solar cells are plated on two sides of the heat conducting substrate 6 and photoetched into series connecting electrodes 8, a light conversion layer is plated on the photoetched series connecting electrodes layer 8 of the solar cells, a transparent electrodes layer is plated on the photoetched solar cells, and further through photoethcing a solar cell pack is made. The solar cell packs on the heat conducting substrate 6 are circled spirally into several layers around the center of the light guiding body insulated against the air, and connected to an electrode of the solar cell pack 16 in connection with the first electrode 1. A light guiding zone around the center of the light guiding body is made through casting a light guiding material 9 and the light reflecting medium 15 is plated on the light guiding zone.

The light reflecting part is as follows. An uneven first light reflecting layer 7, around a center of a cone with the light reflecting medium plated on the electrode of the solar cell pack 16 which is connected to the first electrode 1, and a second light reflecting layer 15 with the light reflecting medium plated on the electrodes layer 8 of the solar cells and the light guiding material 9 form the light mutually reflecting part.

The high-density photons from the light guiding body are evenly totally reflected onto the surface of the solar cell pack of the high-efficiency solar cell 3 through the uneven first light reflecting layer 7 around the center of the cone and the light guiding material 9; the unabsorbed photons on the surface of the solar cell pack of the high-efficiency solar cell 3, from another angle, are totally reflected again onto the surface of the solar cell pack of the high-efficiency solar 3 cell through the light guiding material 9 and the second light reflecting layer 15. Thus the purpose that the solar cell pack of the high-efficiency solar cell 3 can absorb photons reflected from any angle as many as possible is realized and the photovoltaic conversion efficiency of the solar cells is improved.

Referring to Fig. 2 of the drawings, a high-efficiency three-dimensional solar cell comprises an output part of the high-efficiency three-dimensional solar cell, high-efficiency solar cells 3, a shell 5 made of a light guiding material, a light guiding part and a light totally reflecting part.

The output part of the high-efficiency three-dimensional solar cell is as follows. A combination, comprising heat conducting substrates 6 of the high-efficiency solar cells 3, a first electrode 10 for outputting electricity made in close connection, an insulation covering 2 sleeved on the output part of the high-efficiency solar cells, a second electrode 1 for outputting electricity, and air running between the two electrodes, gives the present invention a dual outputting feature of outputting heats through heat exchange between heat conducting substrates 6 of the high-efficiency solar cells 3 and the running air through the two electrodes for outputting electricity 10 and 1, and outputting electricity of the high-efficiency three-dimensional solar cell.

The high-efficiency solar cells 3 are as follows. An insulating layer 4 and an electrodes layer 8 of the solar cells are plated on two sides of a heat conducting substrate 6. The electrodes layer 8 of the solar cells is photoetched into a series connecting electrodes layer 8. A light conversion layer is plated on the photoetched series connecting electrodes layer 8. The light conversion layer is further photoetched into a transparent electrodes layer. Through photoethcing a solar cell pack is formed. The solar cell pack on the heat conducting substrate 6 is circled around a center of the light guiding body in spiral insulated against a room of inert gas 9.

The light guiding part is formed by the inert gas 9.

Photons of the sunlight enter the inert gas 9 through the shell 5 made of the light guiding material and shine directly on a surface of the solar cell pack of the high-efficiency solar cells 3.

The light total reflecting part is made of the light total reflecting medium plated on the first electrode 10.

## Claims

1. A high-efficiency three-dimensional solar cell and a manufacturing method thereof, which is applied in any place needing electricity, such as houses, public places, factories and vehicles like motors and space flights, **characterized in that** the high-efficiency three-dimensional solar cell comprises a light guiding medium, high-efficiency solar cells, a light reflecting medium and an output part for outputting heat and electricity of the high-efficiency three-dimensional solar cell in detachable or fixed connection.

2. The high-efficiency three-dimensional solar cell and the manufacturing method thereof, as recited in claim 1, **characterized in that** a light focusing body or other focusing elements condenses photons when sunlight passes through the light focusing body or other focusing elements, a light focusing and guiding body casts the photons on the light reflecting medium, and the reflecting medium directly reflects the photons onto a surface of the high-efficiency solar cell for absorbing photons, wherein the photons unabsorbed by the surface of the high-efficiency solar cell are reflected repeatedly by the light reflecting medium from any angle onto the surface of the high-efficiency solar cell so as to be totally absorbed by the high-efficiency solar cell, or photons are casted directly on the surface of the high-efficiency solar cells for absorbing the photons and the photons unabsorbed by the surface of the high-efficiency solar cell are reflected again onto the surface of the high-efficiency solar cell through the light reflecting medium to be absorbed again by the high-efficiency solar cells.

3. The high-efficiency three-dimensional solar cell and the manufacturing method thereof, as recited in claim 1, **characterized in that** a light focusing high-efficiency three-dimensional solar cell, made in detachable or fixed connection, comprises a light focusing body made of a material of the light guiding medium having a convex lens or several convex lenses in detachable or fixed connection or other light focusing bodies made in other forms of detachable or fixed connection and a light focusing and guiding body made of the material of the light guiding medium in central symmetry or dissymmetry with the light focusing body, and a high-efficiency solar cell or several high-efficiency solar cells circling around, wherein the high-efficiency solar cells are separated by light guiding mediums, or a side of the light guiding medium is the high-efficiency solar cell, another side of the light guiding medium is the light reflecting medium, or the high-efficiency solar cells coil around, the high-efficiency solar cells are separated by the light guiding mediums, or a side of the light guiding medium is the high-efficiency solar cell, another side of the light guiding medium is the light reflecting medium, and further an output part of the high-efficiency solar cells; another light non-focusing high-efficiency three-dimensional solar cell, made in detachable or fixed connection, comprises a high-efficiency solar cell or several high-efficiency solar cells circling around, wherein the high-efficiency solar cells are separated by light guiding mediums, or a side of the light guiding medium is the high-efficiency solar cell, another side of the light guiding medium is the light reflecting medium, or the high-efficiency solar cells coil around, the high-efficiency solar cells are separated by the light guiding mediums, or a side of the light guiding medium is the high-efficiency solar cell, another side of the light guiding medium is the light reflecting medium, and further an output part of the high-efficiency solar cells.

4. The high-efficiency three-dimensional solar cell and the manufacturing method thereof, as recited in claim 1, **characterized in that** the high-efficiency solar cell is in detachable or fixed connection on a substrate to form a two-sides solar cell or a solar cell pack; or has one side of the solar cells or the solar cell packs and another side of the light guiding medium, in detachable or fixed connection on a substrate.

5. The high-efficiency three-dimensional solar cell and the manufacturing method thereof, as recited in claim 1, **characterized in that** the solar cells or a solar cell pack are separated by and coiled with the light guiding medium; or a piece or several pieces of the solar cells or a solar cell pack in detachable or fixed connection are separated by and coiled with the light guiding medium.

6. The high-efficiency three-dimensional solar cell and the manufacturing method thereof, as recited in claim 1, **characterized in that** the output part of the high-efficiency three-dimensional solar cell comprises conductors, insulating materials and a light reflecting material in detachable or fixed connection, which is a heat exchanger exchanging heat produced by the high-efficiency solar cells with insulating gases or liquids and able to output heat produced from a photovoltaic conversion process and electricity of the high-efficiency three-dimensional solar cell.

7. The high-efficiency three-dimensional solar cell and the manufacturing method thereof, as recited in claim 2, **characterized in that** the light focusing body has each focus thereof, or other light focusing elements have each focus thereof located within a flat scope on the light focusing and guiding body along a vertical axis of the light focusing body.

8. The high-efficiency three-dimensional solar cell and the manufacturing method thereof, as recited in claim 2, **characterized in that** the light focusing and guiding body has convex lenses made of a material of the light guiding medium or convex lens packs in detachable or fixed connection with each other.

9. The high-efficiency three-dimensional solar cell and the manufacturing method thereof, as recited in claim 2, **characterized in that** focuses of the light guiding body or other light focusing elements and the light focusing and guiding body locate within a light reflecting surface of a cone on a light reflecting surface made of the light reflecting medium.
